# EUROPEAN PATENT APPLICATION

(11) **EP 0 557 590 A1**
(43) Date of publication of application: **01.09.1993**
(21) Application number: 92120331.1
(22) Date of filing: 27.11.1992
(51) Int. Cl.: H01L 27/108, H01L 21/82

(54) **Method for manufacturing a capacitor of a semiconductor device**

(30) Priority: 28.02.1992 KR 326592; 15.04.1992 KR 629192; 03.06.1992 KR 961992; 12.11.1992 KR 2123192
(71) Applicant: SAMSUNG ELECTRONICS CO. LTD., Suwon, Kyungki-do (KR)
(72) Inventor: Han, Ki-man, Suwon, Kyungki-do (KR); Hwang, Chang-gyu, Kangnam-ku, Seoul (KR); Kang, Dug-dong, Yongin-gun, Kyungki-do (KR); Choi, Young-jae, Yongin-gun, Kyungki-do (KR); Yoon, Joo-young, Euiwang-city, Kyungki-do (KR)
(74) Representative: TER MEER - MÜLLER - STEINMEISTER & PARTNER

(57) **Abstract**

Disclosed is a method for manufacturing a capacitor of a semiconductor device. After forming a polycrystalline layer (50) composed of grains with microscopic structure to include an impurity (70) in them, the polycrystalline layer is etched to cut the boundary portions of the grains, thereby allowing the surface of the polycrystalline layer to be rugged. The micro-trenches (1) or micro-pillars (11) are formed by using the oxide layer or an anisotropic etching after exposing the surface of the first rugged polycrystalline layer, and epitaxial grains (95) are formed by epitaxial growth, so that cell capacitance can be further increased. The simple process allows the formation of a reliable semiconductor device having regularity and reproducibility, and capable of increasing and adjusting the cell capacitance easily.

## Description

### BACKGROUND OF THE INVENTION

The present invention relates to a method for manufacturing a capacitor of a semiconductor device, and more particularly to a method for manufacturing a capacitor of a semiconductor device utilizing the microscopic structure of a polycrystalline silicon.

The stacked capacitor cell which uses a silicon nitride layer as a dielectric film and a polycrystalline silicon layer as an electrode has been widely adopted in DRAM cells from 1Mb DRAMs. However, along with the trend toward high packing density in DRAMs, sufficient cell capacitance is difficult to secure using the conventional stacked capacitor cells having a simple structure. Thus, methods for enlarging the effective area of a capacitor are being attempted; such as a tantalum oxide layer having high dielectric constant being employed in place of a previously-used silicon nitride as the dielectric film, or changing the structure of the stacked capacitor.

In one method among these methods for enlarging the capacitor's effective area, the polycrystalline silicon layer utilized as a storage electrode of the capacitor is formed so that its surface is rugged. This ruggedness can be attained by an etching of the surface of the polycrystalline silicon layer, or by controlling the generation conditions of the polycrystalline silicon layer during its growth. Here, the latter is considered to be expectant capacitor formation method because it can be realized by a relatively simple process.

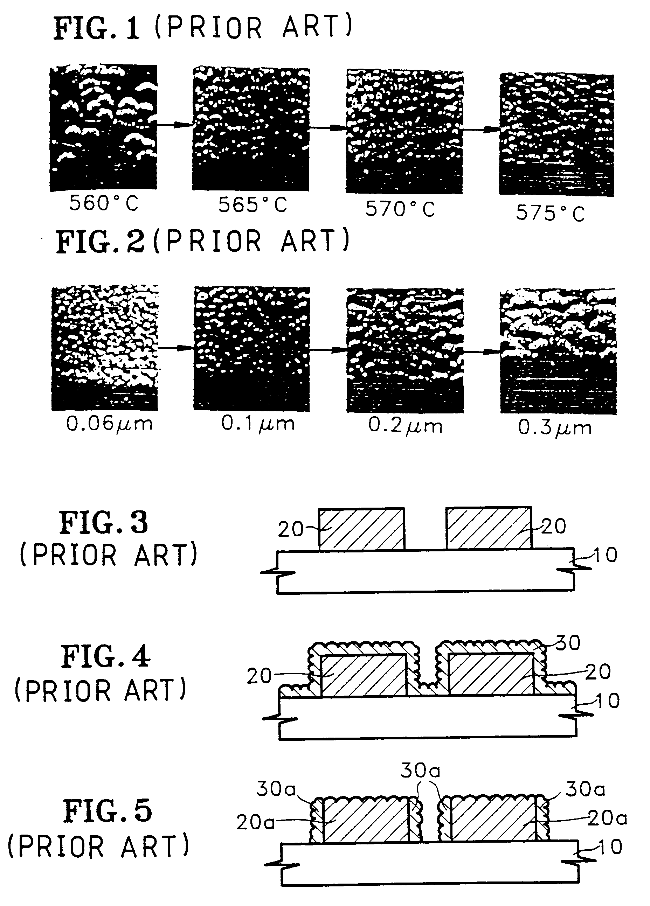

FIGs. 1 & 2 and 3-5 are views for illustrating the conventional methods which control the generation conditions of the polycrystalline silicon layer, to create a rugged surface thereof.

To begin with, a method for making the surface of a polycrystalline silicon layer rugged by controlling the generation conditions thereof which has been suggested by Yoshimura et al. will be explained ("Rugged Surface Poly-Si Electrode and Low Temperature Deposited Si₃N₄ for 64Mbit and beyond STC DRAM Cell" by M. Yoshimura et al., IEDM 1990, pp. 659-662). Here, FIGs. 1 and 2 are photographs for describing the method for manufacturing a capacitor of a semiconductor device by the Yoshimura method. More particularly, FIG. 1 illustrates a prior art technology depicted as a series of SEM photographs which shows the variation in surface morphology (degree of ruggedness) of polycrystalline silicon layer, according to its deposition temperature and for a given deposition thickness (0.1µm). Also, FIG. 2 illustrates a prior art technology depicted as a series of SEM photographs which shows the variation in surface morphology (degree of ruggedness) of a polycrystalline silicon layer, according to its deposition thickness and for a given deposition temperature (570°C).

From the teaching of Yoshimura et al., it can be noted that the degree to which the surface is rugged varies depending upon the deposition temperature (refer to FIG. 1) and deposition thickness (refer to FIG. 2). That is, Yoshimura et al. teach that the surface is most markedly rugged when the polycrystalline silicon layer is deposited to a thickness of 0. 1µm at a temperature of about 570°C. Given a constant capacitor size and structure, the effective cell capacitor area obtained from the use of the rugged polycrystalline silicon layer introduced in the above paper is approximately 2.5 times that obtained by way of a polycrystalline silicon layer having a smooth surface.

FIGs. 3 through 5 are sectional views showing another conventional method for manufacturing the capacitor of the semiconductor device suggested by M. Sakao et al. ("A Capacitor-Over-Bit-line (COB) Cell with a Hemispherical-Grain Storage Node for 64Mb DRAMs" by M. Sakao et al., IEDM 1990, pp. 655-658).

After forming a central storage electrode 20 on a semiconductor substrate 10 (FIG. 3), a polycrystalline silicon layer 30 having hemispherical-grains is deposited on the whole surface of the structure (FIG. 4). Successively, a predetermined anisotropic etching is carried out on the whole surface of the resultant structure, so that the shape of the hemispherical-grain is transferred to the central storage electrode, completing storage electrodes formed of 20a and 30a whose surface is rugged (FIG. 5).

Polycrystalline silicon layer 30 having the hemispherical-grain which is deposited on the resultant structure having the central storage electrode thereon is obtained such that 20% He-diluted silane (SiH₄) is deposited on the semiconductor substrate, in a specific condition of 1.0 torr and at 550°C. This is similar to the method of the paper cited with reference to FIGs. 1 and 2 in that the surface of the polycrystalline silicon layer is also made rugged by controlling the generation conditions of the polycrystalline silicon layer.

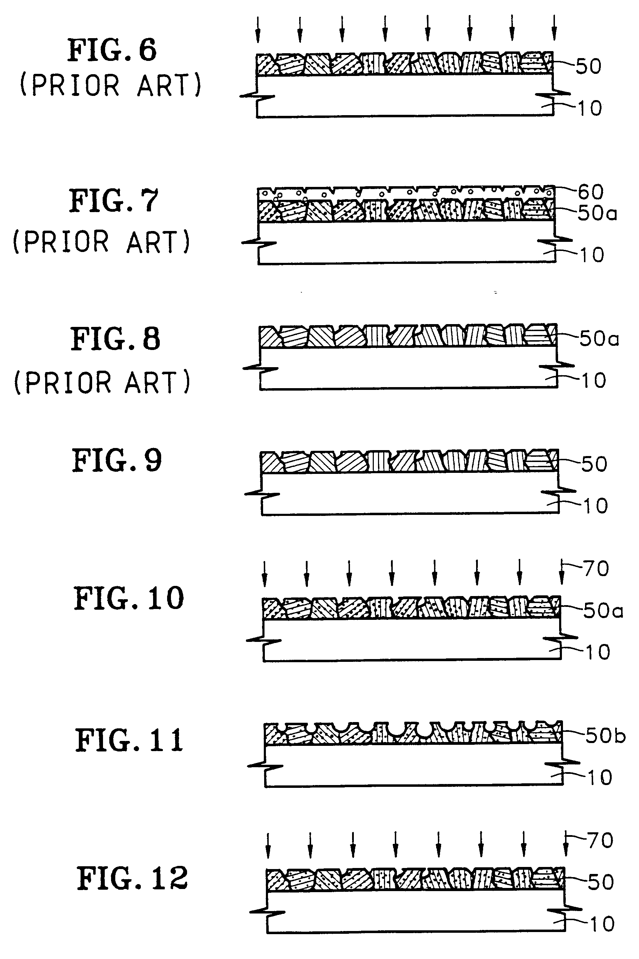

FIGs. 6 through 8 are views for illustrating still another conventional method for manufacturing a semiconductor device suggested by Pierre C. Fazan and Akram Ditali ("Electrical Characterization of Textured Interpoly Capacitors for Advanced Stacked DRAMs" by Pierre C. Fazan and Akram Ditali, IEDM 1990, pp. 663-666).

After depositing a polycrystalline silicon layer 50 to a thickness of about 200-300nm on a semiconductor substrate 10, phosphorus ions are doped (FIG. 6). At this time, the phosphorus ions are for the most part doped on the boundary portions of the grains constituting the polycrystalline silicon layer. This is because the bonding force between the silicon ions of those portions is weaker than that in other portions. Successively, the surface portion of the resultant structure is subjected to a wet oxidization at a temperature of about 907°C. Here, since the water molecules (H₂O) supplied during the wet oxidation, react with the silicon atom constituting the polycrystalline silicon layer in the boundary portions of the grains greater than the other portion, a greater than average amount of silicon dioxide (SiO₂) 60 is generated in this portion, thereby forming rugged polycrystalline silicon layer 50a (FIG. 7). If the resultant structure with the silicon dioxide is wet etched, grooves occur in the portion (i.e., the boundary portions of the grains) with greater silicon dioxide, so that the rugged and uneven polycrystalline silicon layer 50a is obtained (FIG. 8). According to such a method, cell capacitance can be increased by about 34%.

According to the above methods, the surface of the polycrystalline silicon layer is rugged, using the weak bonding force in the boundary portions of the grains constituting the polycrystalline silicon layer. As compared with the effective area of the ordinary polycrystalline silicon layer (whose surface is not rugged), the method for enlarging the effective area by making the surface of the polycrystalline silicon layer rugged greatly contributes to packing density of the DRAMs, since a two to three times larger effective area can be obtained. However, the method for obtaining the ruggedness by controlling conditions for the generation of the polycrystalline silicon layer (FIGs. 1 & 2 and 3-5) has problems with respect to regularity and reproducibility. Also, the method for making the surface rugged by directly etching the polycrystalline silicon layer according to Fazan et al. has problems in securing sufficient cell capacitance.

### SUMMARY OF THE INVENTION

Accordingly, it is an object of the present invention to provide a method for manufacturing a capacitor of a semiconductor device capable of increasing cell capacitance by easily making the surface of a first electrode rugged.

It is another object of the present invention to provide a method for manufacturing a capacitor of a semiconductor device capable of forming a reliable capacitor.

To achieve the above object of present invention, according to the present invention, there is provided a method for manufacturing a capacitor of a semiconductor device including a first electrode, a dielectric film, and a second electrode, wherein a method for forming the first electrode comprises the steps of: forming a polycrystalline layer composed of grains of microscopic structure to allow an impurity to be included within them, on a semiconductor substrate; and etching the polycrystalline layer including the impurity to cut the boundary portions of the grains, so as to make the surface of the polycrystalline layer rugged.

Also, according to the present invention, there is provided a method for manufacturing a capacitor of a semiconductor device including a first electrode, a dielectric film and a second electrode, wherein a method for forming the first electrode comprises the steps of: forming a polycrystalline layer having a rugged surface on a semiconductor substrate; forming an oxide layer on the polycrystalline layer and anisotropically etching the oxide layer formed on the resultant structure to leave the oxide layer between the grains constituting the polycrystalline layer and thus form a mask composed of the oxide layer; forming a micro-trench in the polycrystalline layer by anisotropically etching the rugged polycrystalline layer to a predetermined depth, using the mask composed of the oxide layer as an etch-mask; and removing the etch-mask.

Further, there is provided a method for manufacturing a capacitor of a semiconductor device including a first electrode, a dielectric film and a second electrode, wherein a method for forming the first electrode comprises the steps of: forming a polycrystalline layer having a rugged surface on a semiconductor substrate; forming an oxide layer and anisotropically etching the oxide layer formed on the resultant structure to leave the oxide layer between the grains constituting the polycrystalline layer and thus form an epitaxial mask composed of the oxide material; growing an epitaxial grain on the exposed portion of the rugged polycrystalline layer, using the epitaxial mask; and removing the epitaxial mask.

### BRIEF DESCRIPTION OF THE DRAWINGS

The above objects and other advantages of the present invention will become more apparent by describing in detail a preferred embodiment thereof with reference to the attached drawings in which:
FIG. 1 illustrates a prior art technology depicted as a series of SEM photographs which shows the variation in surface morphology (degree of ruggedness) of a polycrystalline silicon layer, according to its deposition temperature and for a given deposition thickness (0. 1µm);
FIG. 2 illustrates a prior art technology depicted as a series of SEM photographs which shows the variation in surface morphology (degree of ruggedness) of a polycrystalline silicon layer, according to its deposition thickness and for a given deposition temperature (570°C);
FIGs. 3 through 5 are sectional views for illustrating a conventional method for manufacturing a capacitor of a semiconductor device;
FIGs. 6 through 8 are sectional views for illustrating another conventional method for manufacturing a capacitor of a semiconductor device;
FIGs. 9 through 11 are sectional views for illustrating a first embodiment of a method for manufacturing a capacitor of a semiconductor device according to the present invention;
FIGs. 12 through 15 are sectional views for illustrating a second embodiment of a method for manufacturing a capacitor of a semiconductor device according to the present invention;

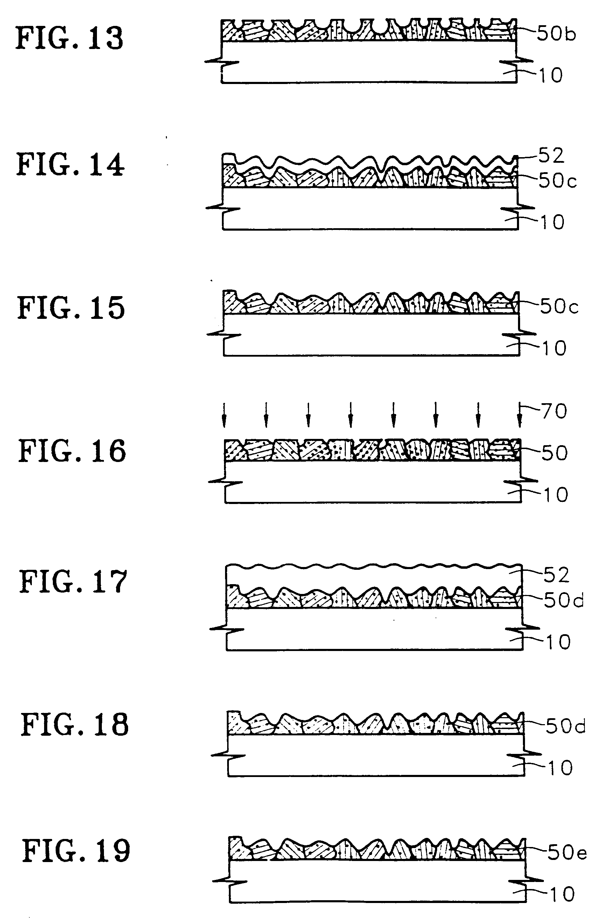

FIGs. 16 through 19 are sectional views for illustrating a third embodiment of a method for manufacturing a capacitor of a semiconductor device according to the present invention;

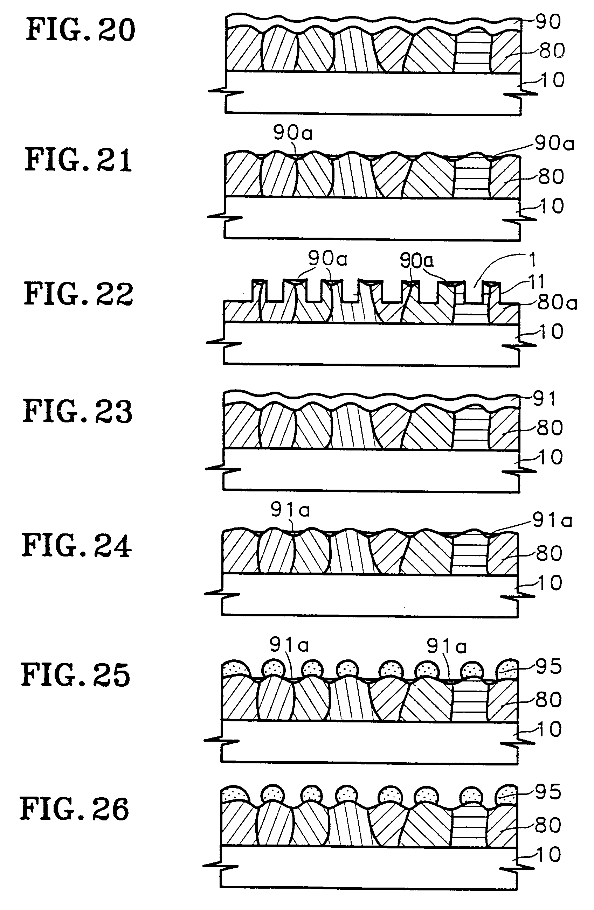

FIGs. 20 through 22 are sectional views for illustrating a fourth embodiment of a method for manufacturing a capacitor of a semiconductor device according to the present invention;
FIGs. 23 through 26 are sectional views for illustrating fifth embodiment of a method for manufacturing a capacitor of a semiconductor device according to the present invention; and

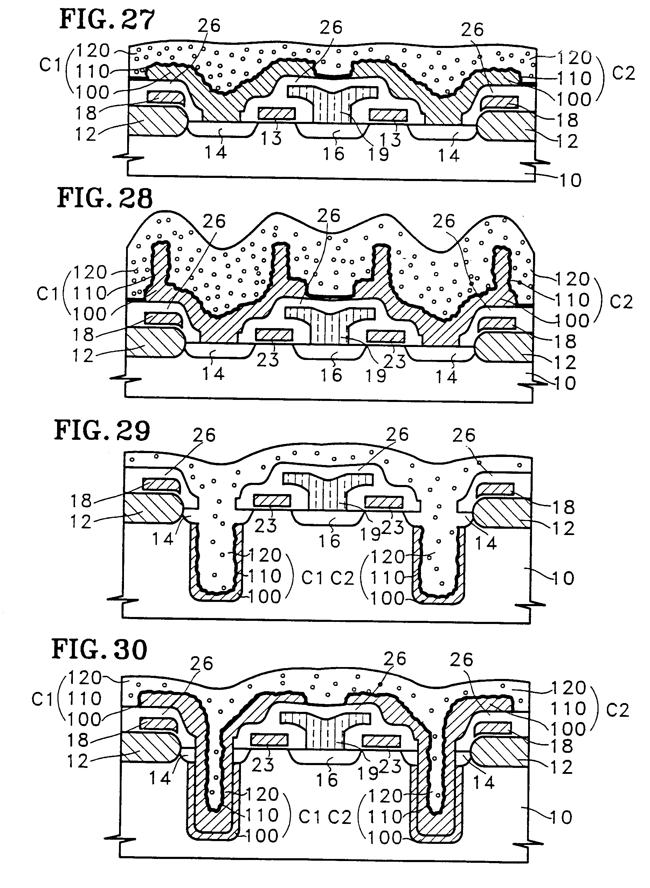

FIGs. 27 through 30 are sectional views showing the various embodiments of the semiconductor device including a capacitor manufactured by the methods for manufacturing a capacitor of a semiconductor device according to the present invention.

### DETAILED DESCRIPTION OF THE PREFERRED EMBODIMENTS

Hereinbelow, the present invention will be described in detail with reference to the accompanying drawings.

### Embodiment 1

FIGs. 9 through 12 are sectional views illustrating a first embodiment of a method for manufacturing a capacitor of a semiconductor device according to the present invention.

First, FIG. 9 shows a step of forming a polycrystalline layer 50 on a semiconductor substrate 10. Here, the polycrystalline layer is formed by depositing a material consisting of a plurality of grains having a microscopic structure on semiconductor substrate 10, using a conventional method, e.g., low-pressure chemical vapor deposition (LPCVD). At this time, the material consists of the plurality of microscopic grains whose crystalline structures are different from one another, wherein the grain size depends on the temperature, time and thickness of the material's deposition, and adjacent grains have different crystalline structures from one another.

In this embodiment, the deposition temperature is about 500-700°C but should not be taken in a limiting sense. Also, an amorphous silicon, a polycrystalline silicon or a polycrystalline silicon having hemispherical grains may be utilized as the polycrystalline layer.

FIG. 10 shows a step of doping an impurity 70 on the whole surface of the resultant structure. Using a material such as phosphorous oxychloride (POCl₃), a doped-polycrystalline layer 50a is formed by doping phosphorus ions into polycrystalline layer 50. Then, as shown in FIG. 10, the phosphorus ion reacts with the silicon ion much more in the boundary portions, so that the concentration of the phosphorus ion in the boundary portions becomes higher than in other portions. This is because the bonding force between silicon ions is weak in the boundary portions of the grains as described with reference to FIG. 6.

At this time, the grain sizes differ in conjunction with the concentration of the impurity, and when the concentration of the impurity is high, the grain size is large (as compared with that in low concentration). This is because, the higher concentration of the impurity is, the longer the required doping time is, so that the heat energy supplied during the doping process alters the crystalline structure of the grains and thus allows the grains to be coupled with adjacent grains, which causes a phenomenon creating greater grain size.

FIG. 11 shows a step of obtaining a rugged polycrystalline layer 50b by etching the doped polycrystalline layer 50a. When the resultant structure obtained in FIG. 10 is etched by being exposed to a phosphoric acid (a wet etching or a dry etching), the portions where the concentration of the phosphorus ion is high, i.e., the boundary portions of the grains in the polycrystalline silicon, are more deeply etched than the other portions, which results in the rugged polycrystalline layer 50b. This is because the phosphoric acid etches a material including phosphor more than a material without phosphor.

According to another embodiment of the present invention, an impurity as the reference numeral 70 in FIG. 10 (a phosphorus ion is used in the present embodiment) which has been doped on the unrugged polycrystalline layer (reference numeral 50 in FIG. 9) is preferably doped again on the rugged polycrystalline layer 50b, which makes the capacitance uniformity (Cmin/Cmax) of the rugged polycrystalline layer 50b good.

When doping the impurity for activating after forming the polycrystalline layer, a large amount of the impurity is concentrated especially in the boundary portions of the grains, so that, relatively, the amount of doping in the interior and lower portions of the grains becomes small. If an etching is carried out utilizing this phenomenon, the doping concentration on the rugged surface becomes extremely small. In other words, the poor overall doping uniformity deteriorates the capacitance uniformity, which in turn worsens memory characteristics. Thus, the capacitance uniformity is enhanced by re-doping the impurity on the rugged surface. At this time, unrugged polycrystalline layer 50 is doped with an impurity whose concentration is such that the undoped polycrystalline silicon has an average sheet resistance of about 55Ω/□. Also, rugged polycrystalline layer 50b is doped with an impurity whose concentration is to allow the polycrystalline silicon without being doped with the impurity to have an average sheet resistivity of about 80Ω/□.

The re-doping of the impurity on the rugged polycrystalline layer can be adopted to the following embodiments to be described, or can be omitted as required.

### EMBODIMENT 2

FIGs. 12 through 15 are sectional views illustrating a second embodiment of a method for manufacturing a capacitor of a semiconductor device according to the present invention.

First, FIG. 12 shows a step of forming a polycrystalline layer 50 on a semiconductor substrate 10. Using a conventional method, e.g., LPCVD or the like, a material consisting of a plurality of grains having microscopic structure is deposited on the semiconductor substrate, thereby forming polycrystalline layer 50. Here, the material consists of a plurality of grains each having different microscopic structure wherein the sizes of the grains depend on the material deposition temperature, time and thickness, and adjacent grains have different crystalline structure from one another.

In the present embodiment, the deposition temperature of the material is limited at 500-700°C, but not in an absolutely limiting sense. The material constituting the polycrystalline layer is any one among an amorphous silicon, a polycrystalline silicon and a polycrystalline silicon having hemispherical grains. Successively, a process for doping impurity 70 on the polycrystalline layer is carried out, which may be performed after forming the polycrystalline layer or simultaneously performed during the deposition of the material constituting the polycrystalline layer. In the present embodiment, the phosphorus ion is doped on the polycrystalline layer, using a material such as POCl₃, but the impurity is not limited to the phosphorus ion. The phosphorus ion doped on the polycrystalline layer reacts to the silicon ion much more in the boundary portions, so that the concentration of the phosphorus ion in the boundary portions becomes higher than in other portions. This is because the bonding force between silicon ions is weak in the boundary portions of the grains as described with reference to FIG. 6 in Embodiment 1.

At this time, the grain sizes differ in conjunction with the concentration of the impurity and the heat energy supplied during doping. When the impurity concentration is high, the grain size is larger than with low concentration. This is because higher impurity concentration requires a longer doping time, so that the heat energy supplied during the doping process alters the crystalline structure of the grains and thus allows adjacent grains to couple; this phenomenon results in greater grain size. In order to adjust the size of the grain, thermal treatment may be added after doping the impurity.

FIG. 13 illustrates a step of etching polycrystalline layer 50. When the resultant structure obtained in FIG. 12 is etched by using a phosphoric acid (via wet etching or dry etching), those portions where phosphorus ion concentration is high, i.e., the boundary portions of the grains in the polycrystalline silicon. are more deeply etched than the other portions, which results in the rugged polycrystalline layer 50b. This is because the phosphoric acid etches materials including phosphor more than those without. It is no doubt that, if another material is used as the impurity doped on the polycrystalline silicon, the etchant must be changed.

Generally, the etching solution of the impurity should well etch the material including the impurity. For instance, if the phosphorus ion is employed as the impurity in the embodiment of the present invention, a phosphoric acid superior to any other solution which can etch the material including the phosphorus ion more than those without, must be used.

FIG. 14 illustrates a step of growing an oxide layer 52 on the whole surface of rugged polycrystalline layer 50b. When rugged polycrystalline layer 50b is exposed to an oxidizing ambient (wet or dry), the silicon atoms constituting the polycrystalline layer reacts with the oxygen atoms. As a result, a thin oxide layer 52 is grown on the surface of the polycrystalline layer, which makes polycrystalline layer 50b even more rugged. A reference numeral 50c represents the secondarily formed rugged polycrystalline layer made so by such etching and oxidation processes. At this time, the oxide layer growth is greater in the boundary portions of the grains, which is because the bonding force between silicon atoms is weak in the grain boundary portions as mentioned with reference to FIG. 7.

FIG. 15 illustrates a step of eliminating oxide layer 52. Here, the resultant structure on which oxide layer 52 is grown is exposed to oxide etching solution (dry or wet), removing oxide layer 52.

The step of removing oxide layer 52 after having been grown on polycrystalline layer 50b (two steps described with reference to FIGs. 14 and 15) not only removes the sharp portions of the polycrystalline layer whose surface is made rugged by the phosphoric acid, but also, by the oxide layer well grown in the grain boundary portions, forms a more rugged polycrystalline layer than polycrystalline layer 50b shown in FIG. 11. This prevents a leakage current occurring at the sharp portions, so that reliability of the memory is enhanced and a cell capacitance larger than that obtainable in FIG. 11 can be secured.

### EMBODIMENT 3

FIGs. 16 through 19 are sectional views illustrating a third embodiment of a method for manufacturing a capacitor of a semiconductor device according to the present invention, which is executed according to partially changed sequence of the steps of the second embodiment.

The third embodiment will be described with reference to the second embodiment hereinafter. In the second embodiment, after forming the polycrystalline layer, its surface is made rugged using the phosphoric acid, and then the oxide growing and removing steps are carried out. Meanwhile, in the third embodiment, the oxide layer is grown and removed immediately after forming the polycrystalline layer, and successively, the phosphoric acid is used. At this time, the surface of the polycrystalline layer is made rugged once during the oxide layer growing and removing steps, and a second time during the etching step, using the phosphoric acid.

FIG. 16 illustrates a step of forming polycrystalline layer 50 on semiconductor substrate 10. As described with reference to FIG. 12, using the ordinary method, e.g., LPCVD, etc., a material consisting of a plurality of grains having the microscopic structure is deposited on the semiconductor substrate, thereby forming polycrystalline layer 50.

FIG. 17 illustrates a step of growing oxide layer 52 on the whole surface of polycrystalline layer 50. When polycrystalline layer 50 is exposed to an oxidizing ambient (wet or dry), the silicon atoms constituting the polycrystalline layer react to the oxygen atoms, so that thin oxide layer 52 is grown on the surface of the polycrystalline layer, which in turn makes polycrystalline layer 50 rugged to thus obtain rugged polycrystalline layer 50d.

FIG. 18 illustrates a step of removing oxide layer 52. The resultant structure having grown oxide layer 52 thereon is exposed to an oxide etching solution (dry or wet), thereby removing oxide layer 52.

FIG. 19 illustrates a step of etching rugged polycrystalline layer 50d. When rugged polycrystalline layer 50d obtained in FIG. 18 is exposed to the etching process (wet or dry etching), using the phosphoric acid, the portions where the concentration of the phosphorus ion is high, i.e., the boundary portions of the grains in the polycrystalline silicon, are more deeply etched than the other portions, which results in secondly rugged polycrystalline layer 50e.

### EMBODIMENT 4

FIGs. 20 through 22 are sectional views illustrating a fourth embodiment of a method for manufacturing a capacitor of a semiconductor device according to the present invention, wherein cell capacitance is greater than any of those obtained by means of the methods of the first, second and third embodiments.

First, FIG. 20 illustrates a step of forming an etch-mask layer 90 on the resultant structure after forming rugged polycrystalline layer 80 in accordance with the methods of the first to third embodiments, or the known method.

A process for forming polycrystalline layer 80 with rugged surface is performed on semiconductor substrate 10, using the method of the first to third embodiments or a known method. Then, etch-mask layer 90 is formed by depositing a material which has a different etch rate from the material constituting polycrystalline layer 80, e.g., an oxide, on the whole surface of the polycrystalline layer, using a chemical vapor deposition or a thermal oxidation. At this time, it rugged polycrystalline layer 80 is formed by the method described with reference to FIGs. 12 through 15, the steps described in FIG. 20 can be executed without removing the oxide layer (reference numeral 52 in FIG. 14).

FIG. 21 illustrates a step of forming an etch-mask 90a, wherein a material constituting the etch-mask layer on the whole surface of the resultant structure is anisotropically etched using the upper surface of the polycrystalline layer as an etching end-point, so that the oxide is left only in grooves of rugged polycrystalline layer 80, forming etch-mask 90a.

FIG. 22 illustrates a step of forming a micro-trench 1 and a micro-pillar 11. Here, polycrystalline layer 80 on the whole surface of the resultant structure on which etch-mask 90a is formed is anisotropically etched, using etch-mask 90a, so that the polycrystalline layer is etched to a predetermined depth, thereby forming micro-pillar 11 on the lower portion of etch-mask 90a and micro-trench 1 on the other portions. At this time, the predetermined depth may be as much as but not more than the thickness of the polycrystalline layer. In the case of the former, the micro-pillars are separated when viewing from the sectional view, but if viewed from above, micro-pillars are all connected together. (Although not shown in the drawing, micro-trench 1 partially exposes semiconductor substrate 10 in FIG. 22.) Then, rugged polycrystalline layer 80a is obtained by removing etch-mask 90a.

According to the fourth embodiment of the present invention, a micro-trench is formed in the polycrystalline layer whose surface has been made rugged by means of any one of the methods of the first, second and third embodiments, thus forming a polycrystalline layer having a surface area capable of obtaining a cell capacitance larger than that of the polycrystalline layer formed by the method of the first to third embodiments.

### EMBODIMENT 5

FIGs. 23 through 26 are sectional views illustrating a fifth embodiment of a method for manufacturing a capacitor of a semiconductor device according to the present invention.

FIG. 23 illustrates a step of forming an epitaxial mask layer 90 on the whole surface of the resultant structure after forming rugged polycrystalline layer 80 in accordance with the methods of first to third embodiment, or the known method, as FIG. 20 in the fourth embodiment. A process for forming polycrystalline layer 80 with rugged surface is performed on semiconductor substrate 10, using the method of the first to third embodiments or a known method as in forming etch-mask layer 90 in the fourth embodiment. Then, epitaxial mask layer 91 is formed by coating a material different from the material constituting polycrystalline layer 80, e.g., an oxide or a spin-on-glass (SOG), on the whole surface of the polycrystalline layer, using a chemical vapor deposition or a thermal oxidation.

FIG. 24 illustrates a step of forming an epitaxial mask 91a. Like the formation of etch-mask 90a in fourth embodiment, an anisotropic etching is carried out upon the material constituting epitaxial mask layer 91 down to the upper surface of polycrystalline layer 80. Thus, epitaxial mask 91a is formed by leaving the oxide only in the grooves of rugged polycrystalline layer 80, and the upper portion of rugged polycrystalline layer 80 consisting of grains is exposed.

FIG. 25 illustrates a epitaxial growth step. Using SiH₂Cl₂ + HCl system as a source and a hydrogen gas as a carrier, and using the exposed top portions of the rugged polycrystalline layer as a seed, the whole surface of the resultant structure on which epitaxial mask 91a is formed is epitaxially grown to a predetermined height, forming epitaxial grains 95. At this time, the predetermined height is preferably 50-500Å.

FIG. 26 illustrates a step of removing epitaxial mask 91a. After the epitaxial growth step, epitaxial mask 91a is removed by a conventional method to obtain rugged polycrystalline layer 80 having epitaxial grains 95.

According to the above fifth embodiment, a capacitor electrode with large surface area can be obtained as in the fourth embodiment, while the process is simple as compared with the phosphoric acid treatment. In addition, the etching damage occurring in the fourth embodiment can be decreased.

In the above-described all embodiments, it is without doubt that the processes for making the surface of the polycrystalline layer rugged can be carried out on the polycrystalline layer pattern which has been previously formed for a first electrode formation. Furthermore, the enhancement of the cell capacitance can be contrived such that the silicon nitride layer and a high-temperature oxide layer is stacked on the semiconductor substrate before patterning the polycrystalline layer, and then, after forming the first electrode, a partial removing of the high-temperature oxide layer is added.

FIGs. 27 through 30 are sectional views showing the semiconductor devices by the embodiments of the methods for manufacturing the capacitor of the semiconductor device according to the present invention. FIG. 27 shows a semiconductor device having the stacked capacitor structure, FIG. 28 shows a semiconductor device having the cylindrical capacitor structure, FIG. 29 shows a semiconductor device having the trench capacitor structure, and FIG. 30 shows a semiconductor device having the stacked-trench capacitor structure; all of these adopt the method according to the present invention.

In FIGs. 27 through 30, a reference numeral 10 denotes a semiconductor substrate, 12 is a selectively grown field oxide layer, 23 is a gate electrode, 14 is a source region, 16 is a drain region, 100 is a storage electrode, 110 is a dielectric film, 120 is a plate electrode, 19 is a bit line, 18 is a word line, 26 is an insulating layer, and reference symbols C1 and C2 are capacitors.

According to the method for manufacturing a capacitor of a semiconductor device, after doping a predetermined impurity on a polycrystalline layer consisting of microscopic grains having different crystalline structures from one another, the surface of a first electrode is first rugged by an etching process of the polycrystalline layer, using an etchant which can especially etches the predetermined impurity, and then the surface of the first electrode is secondly rugged by proceeding an oxide layer growing and removing processed on the surface of the rugged polycrystalline layer. Therefore, the adoption of the method to memory cells which are being increased in packing density, is expected, because it has regularity and reproducibility, and the extremely simple process makes the increase and adjustment of cell capacitance easy.

In addition, by using the oxide layer or an anisotropic etching after exposing the surface of the first rugged polycrystalline layer, and then forming the micro-trenches or micro-pillars, or forming epitaxial grains by epitaxial growth, cell capacitance can be further increased.

While the present invention has been particularly shown and described with reference to particular embodiments thereof, it will be understood by those skilled in the art that various changes in form and details may be effected therein without departing from the spirit and scope of the invention as defined by the appended claims.

## Claims

1. In a method for manufacturing a capacitor of a semiconductor device including a first electrode, a dielectric film, and a second electrode, a method for forming said first electrode comprising the steps of:
forming a polycrystalline layer (50a) composed of grains of microscopic structure to allow an impurity to be included within them, on a semiconductor substrate; and
etching said polycrystalline layer (50a) including said impurity to cut into the boundary portions of said grains, so as to make the surface of said polycrystalline layer rugged.

2. A method for manufacturing a capacitor of a semiconductor device as claimed in claim 1, further comprising a step of patterning said polycrystalline layer (50a), performed after said step of forming said polycrystalline layer.

3. A method for manufacturing a capacitor of a semiconductor device as claimed in claim 1, before said step of making said surface of said polycrystalline layer rugged (50a), further comprising the steps of:
forming an oxide layer (52) on the whole surface of the resultant structure; and
removing said oxide layer.

4. A method for manufacturing a capacitor of a semiconductor device as claimed in claim 1, after said step of making the surface of said polycrystalline layer rugged, further comprising the steps of:
forming an oxide layer (52) on the whole surface of the resultant structure; and
removing said oxide layer.

5. A method for manufacturing a capacitor of a semiconductor device as claimed in claim 1, after said step of making the surface of said polycrystalline layer rugged further comprising the steps of:
forming an oxide layer (90), anisotropically etching said oxide layer formed on the resultant structure, and leaving said oxide layer between said grains constituting said polycrystalline layer to form a mask (90a) composed of said oxide layer: and
forming a micro-trench (1) in said polycrystalline layer by anisotropically etching said rigged polycrystalline layer (80) to a predetermined depth, using said mask (90a) composed of said oxide layer as an etch-mask.

6. A method for manufacturing a capacitor of a semiconductor device as claimed in claim 5, wherein said predetermined depth is smaller than of equals to the thickness of said polycrystalline layer.

7. A method for manufacturing a capacitor of a semiconductor device as claimed in claim 1, after said step of making the surface of said polycrystalline layer rugged, further comprising the steps of:
forming an oxide layer (91), anisotropically etching said oxide layer formed on the resultant structure, and leaving said oxide layer between said grains constituting said polycrystalline layer to form an epitaxial mask (91a) composed of said oxide layer (91); and
growing an epitaxial silicon grain on the exposed portion of said rugged polycrystalline layer (80), using said mask (91a) composed of the oxide material.

8. A method for manufacturing a capacitor of a semiconductor device as claimed in claim 1, wherein said impurity (70) is doped during or after depositing said polycrystalline layer.

9. A method for manufacturing a capacitor of a semiconductor device as claimed in claim 8, wherein said impurity is doped again on the whole surface of the resultant structure after said step of making said surface of said polycrystalline layer rugged.

10. A method for manufacturing a capacitor of a semiconductor device as claimed in claim 1, wherein said step of making said surface of said polycrystalline layer (50a) rigged by cutting the boundary portions of said grains of said polycrystalline layer (50) is carried out, using an etchant which can especially etch said impurity well.

11. A method for manufacturing a capacitor of a semiconductor device as claimed in claim 10, wherein an phosphorus ion is used as said impurity (70), and a phosphoric acid is used as said etchant.

12. A method for manufacturing a capacitor of a semiconductor device as claimed in claim, 3, wherein said oxide layer (52) is formed via a chemical vapor deposition or a heat treatment.

13. A method for manufacturing a capacitor of a semiconductor device as claimed in claim 1, wherein a polycrystalline silicon layer, an amorphous silicon layer, and a polycrystalline silicon layer having hemispherical grains are used as said polycrystalline layer (50).

14. A method for manufacturing a capacitor of a semiconductor device as claimed in claim 1, wherein the capacitor formation method for making said polycrystalline layer rigged is adopted to a stacked, a trench and a stacked-trench structures.

15. A method for manufacturing a capacitor of a semiconductor device as claimed in claim 1, further comprising the steps of stacking a silicon nitride layer and a high temperature oxide (HTO) layer on the whole surface of said semiconductor substrate before said step of patterning said polycrystalline layer (50); and removing a portion of said HTO layer after completing said first electrode.

16. A method for manufacturing a capacitor of a semiconductor device including a first electrode, a dielectric film and a second electrode, wherein a process for forming said first electrode comprises the steps of:
forming a polycrystalline layer (80) having rugged surface on a semiconductor substrate:
forming an oxide layer (90) on said polycrystalline layer (80), anisotropically etching said oxide layer formed on the resultant structure, and leaving said oxide layer between said grains constituting said polycrystalline layer to form a mask (90a) composed of said oxide layer; and
forming a micro-trench (1) in said polycrystalline layer (80) by anisotropically etching said rugged polycrystalline layer to a predetermined depth, using said mask (90a) composed of said oxide layer as an etch-mask.

17. A method for manufacturing a capacitor of a semiconductor device as claimed in claim 16, wherein said predetermined depth is less than or equal to the thickness of said polycrystalline layer (80).

18. A method for manufacturing a capacitor of a semiconductor device including a first electrode, a dielectric film and a second electrode, wherein a process for forming said first electrode comprises the steps of:
forming a polycrystalline layer (80) having rugged surface on a semiconductor substrate:
forming an oxide layer (91) on said polycrystalline layer (80), anisotropically etching said oxide layer (91) formed on the resultant structure, and leaving said oxide layer between said grains constituting said polycrystalline layer to form an epitaxial mask (91a) composed of the oxide material; and
growing an epitaxial grain (95) on the exposed portion of said rugged polycrystalline layer (80), using said epitaxial mask.

19. A method for manufacturing a capacitor of a semiconductor device as claimed in claim 18, wherein said step of growing said epitaxial grain (95) is carried out, using SiH₂Cl₂ + HCl system as a source and using a hydrogen gas as a carrier.
